# FASCICULE DE BREVET EUROPEEN

(11) **EP 1 074 846 B1**
(45) Date de publication et mention de la délivrance du brevet: **14.02.2007**
(21) Numéro de dépôt: 00402137.4
(22) Date de dépôt: 26.07.2000
(51) Int. Cl.: G01R 15/18, G01R 15/20, G01R 3/00, H01F 38/30

(54) **Capteur de courant pour appareil électrique**
Stromsensor für eine elektrische Vorrichtung
Current sensor for an electrical device

(30) Priorité: 04.08.1999 FR 9910169
(43) Date de publication de la demande: 07.02.2001
(73) Titulaire: SCHNEIDER ELECTRIC INDUSTRIES SAS, 92500 Rueil-Malmaison (FR)
(72) Inventeur: Baurand, Gilles, 78360 Montesson La Borde (FR); Cuny, Jean-Christophe, 92500 Rueil-Malmaison (FR); Gladovic, Vjekoslav, 10190 Thuisy/Estissac (FR); Lemarchand, Patrick, 78200 Magnanville (FR); Trico, Jean-Marie, 92600 Asnières-sur-Seine (FR)

(56) Documents cités:
- DE-A- 3 518 651
- FR-A- 2 163 581
- US-A- 4 746 891
- US-A- 4 794 326
- US-A- 5 027 059
- US-A- 5 587 651
- US-A- 5 617 019

## Description

La présente invention concerne un capteur de courant pouvant être utilisé dans des appareils électriques de puissance tels que des disjoncteurs, des relais de puissance pour assurer les fonctions de protection thermique, magnétique ou de court-circuit.

Les capteurs de courant comprenant un circuit primaire dans lequel circule un courant électrique à mesurer, un circuit magnétique à entrefer et un circuit secondaire délivrant un signal représentatif du courant à mesurer, sont bien connus.

Certains types de capteurs de courant prévoient un circuit magnétique en forme de tore autour duquel vient s'enrouler un bobinage secondaire faisant office de détecteur de champ magnétique. Cette disposition peut entraîner des coûts de fabrication importants du bobinage secondaire liés à la forme torique du circuit magnétique, par rapport à une forme cylindrique.

D'autres types de capteurs de courant possèdent un circuit magnétique ne présentant qu'un seul entrefer. Ils sont de ce fait plus sensibles à d'éventuelles perturbations provenant de champs magnétiques extérieurs, pouvant nécessiter ainsi un blindage métallique autour du bobinage secondaire ou un circuit électronique spécifique en aval du bobinage secondaire de façon à limiter l'effet de ces perturbations. De plus, la dynamique du capteur peut alors s'en trouver réduite.

Enfin, le document US 5617019 décrit un capteur de courant comprenant un circuit magnétique fait de deux entrefers situés entre deux parties symétriques en forme de U et comprenant deux bobines secondaires placées soit à l'intérieur, soit autour des deux entrefers. Dans ce capteur de courant, le circuit primaire ne traverse qu'une seule fois le circuit magnétique, ce qui rend le capteur peu sensible pour des faibles valeurs du courant primaire. De plus, ce capteur nécessite une prise d'information entre les deux bobines, entraînant un point de connexion électrique réclamant donc une soudure, en vue d'une utilisation dans un traitement électronique aval.

La présente invention a pour but de réaliser un capteur de courant présentant une bonne immunité vis-à-vis des champs magnétiques extérieurs, ayant un encombrement réduit, mais surtout couvrant une large plage de réglage du courant primaire et dont la fabrication en grande série puisse se faire de façon la plus simple et la plus économique possible.

Selon l'invention, le capteur de courant, implantable dans un appareil électrique pour assurer des fonctions de protection thermique, magnétique ou de court-circuit, comporte un circuit primaire dans lequel circule un courant électrique à mesurer, un circuit secondaire faisant office de détecteur de champ magnétique, un circuit magnétique comprenant deux éléments identiques en forme de U, composés d'un matériau ferromagnétique et possédant chacun une première et une seconde branches parallèles. Deux entrefers, ayant une épaisseur sensiblement égale, sont situés respectivement entre chaque première branche et chaque seconde branche des éléments. Le circuit secondaire comporte deux bobines similaires de plusieurs spires, de forme cylindrique, montées en série, chaque bobine du circuit secondaire étant disposée de façon symétrique par rapport à un plan médian passant par les entrefers du circuit magnétique. Ce capteur est caractérisé par le fait que les deux bobines sont réalisées en continu par une seule opération de bobinage sans soudure entre les deux bobines, et par le fait que le circuit primaire est constitué d'un conducteur électrique formant un enroulement de forme cylindrique de section constante, entourant une des deux bobines du circuit secondaire et disposé de façon symétrique par rapport au plan médian, ledit conducteur électrique faisant un nombre de passages entre les bobines supérieur à 1.
La réalisation des deux bobines en continu par une seule opération de bobinage sans soudure entre les deux bobines simplifie leur fabrication en série.

Le capteur est conçu pour pouvoir s'adapter à plusieurs calibres de courant primaire en faisant varier le nombre de passages du circuit primaire autour des bobines du circuit secondaire, le nombre de spires du circuit secondaire et l'épaisseur des entrefers, tout en gardant un signal de sortie sensiblement linéaire et identique, rendant ainsi son utilisation la plus étendue et donc la plus économique possible.

L'invention va maintenant être décrite avec plus de détails en se référant à des modes de réalisation donnés à titre d'exemple et représentés par les dessins annexés sur lesquels :
- la figure 1 représente une vue en coupe d'un mode de réalisation du capteur de courant conforme à l'invention,
- la figure 2 est une vue de côté suivant le même mode de réalisation,
- la figure 3 détaille un schéma de raccordement du circuit secondaire,
- la figure 4 montre un autre mode de réalisation dans lequel le conducteur du circuit primaire traverse le circuit magnétique en ne faisant qu'un seul passage complet,
- les figures 5 et 6 représentent des vues en coupe d'exemples de forme du circuit primaire suivant le mode de réalisation de la figure 4.

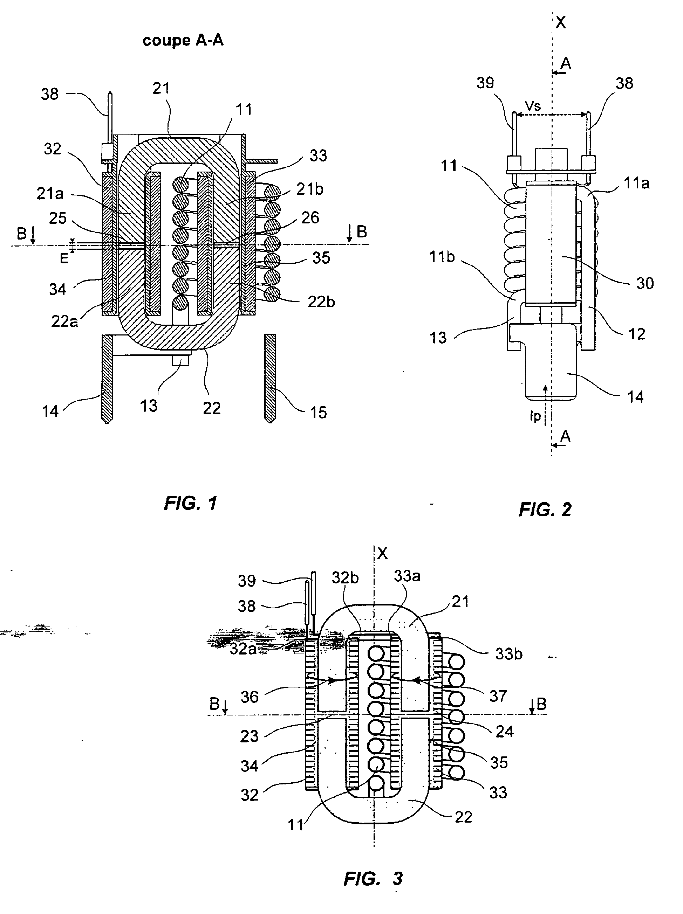

Le capteur de courant représenté dans la figure 1 est utilisable dans tout appareil électrique interrupteur de puissance du type contacteur/disjoncteur, disjoncteur ou autre pour assurer des fonctions de protection thermique, magnétique et protection sur court-circuit. Un appareil électrique peut inclure un ou plusieurs capteurs de courant décrit dans l'invention (typiquement un capteur par phase par exemple). Le capteur de courant possède un circuit magnétique qui comporte deux éléments identiques 21,22 en forme de U aux angles arrondis. Ces deux éléments 21,22 sont préférentiellement réalisés à partir d'un profilé étiré de section circulaire ce qui rend leur fabrication très économique. Chaque élément 21,22 possède deux branches droites parallèles de forme cylindrique respectivement 21a,21b et 22a,22b de longueur et de section sensiblement égales. Ces deux éléments 21,22 sont disposés en vis-à-vis de telle manière que les deux branches 21a,22a d'une part et 21b,22b d'autre part soient alignées et coplanaires. Le circuit magnétique comporte également deux entrefers 23,24 qui sont matérialisés par deux pastilles 25,26 identiques, constituées d'un matériau a-magnétique, d'épaisseur E et de section circulaire sensiblement égale à la section des éléments 21,22. Ces pastilles 25,26 sont placées aux extrémités des branches respectivement 21a,22a et 21b,22b de telle façon que les éléments 21,22 viennent en appui sur ces pastilles.

Le circuit secondaire comporte deux bobines similaires 32,33 de forme cylindrique, comportant un nombre égal de spires Ns, à partir d'un fil conducteur mince émaillé et réparties de façon homogène sur respectivement deux carcasses 34,35 de faible épaisseur également de forme cylindrique, formant ainsi deux sous-ensembles cylindriques 30,31. Le sous-ensemble 30 entoure la branche 21a, l'entrefer 23 et la branche 22a du circuit magnétique et le sous-ensemble 31 entoure la branche 21b, l'entrefer 24 et la branche 22b du circuit magnétique. Les sous-ensembles 30,31 sont disposés de façon symétrique par rapport à un plan horizontal médian B-B passant par les deux entrefers 23,24 et sont parallèles à un axe vertical X orthogonal à ce plan médian B-B.

En sortie de circuit secondaire, deux connecteurs 38,39 situés dans une direction sensiblement parallèle à l'axe vertical X, permettent de récupérer un signal de sortie Vs fourni par le capteur. La figure 3 montre un exemple de schéma de raccordement du circuit secondaire dans lequel le connecteur 38 est raccordé à l'extrémité 32a de la bobine 32, le connecteur 39 est raccordé à l'extrémité 33b de la bobine 33. La forme cylindrique de ces bobines 32,33, par rapport à une forme torique par exemple, présente l'avantage de simplifier sensiblement la réalisation du bobinage.

Comme indiqué au moyen des flèches 36,37 de la figure 3, les deux bobines 32,33 sont disposées en série avec un sens de bobinage opposé de manière à se rapprocher magnétiquement du comportement d'un tore, tout en gardant un procédé de fabrication simple, et de manière à annuler l'influence des champs magnétiques extérieurs par compensation différentielle, contrairement à ce que l'on obtiendrait avec un circuit magnétique ne possédant qu'un seul entrefer. De plus, il est avantageux de réaliser un nombre pair de couches de bobinage pour chaque sous-ensemble 30,31 de façon à favoriser cet effet de compensation différentielle des champs magnétiques extérieurs.

Les deux bobines 32,33 s'apparentent en réalité à un seul enroulement physiquement réparti de façon identique autour des deux carcasses cylindriques 34,35 pour former les deux sous-ensembles 30,31. Cet enroulement est réalisé de façon continue par une seule opération de bobinage autour des carcasses cylindriques 34,35, leur section circulaire présentant l'avantage de diminuer les tensions pouvant apparaître sur le fil conducteur du circuit secondaire lors du bobinage. Comme l'opération de bobinage est faite en continu, il n'est pas nécessaire d'avoir de connexion électrique entre les bobines 32,33, ce qui évite la réalisation d'une soudure entre les bobines. Ainsi, deux soudures seulement (pour raccorder les connecteurs 38 et 39) sont nécessaires à la réalisation du circuit secondaire, alors qu'il faudrait trois ou quatre soudures si les deux bobines 32,33 étaient fabriquées séparément puis raccordées en série, ou s'il y avait nécessité de prendre une information au point milieu des deux bobines, par exemple en vue d'une utilisation dans un traitement électronique en aval du capteur.

Selon le mode de réalisation de la figure 1, le circuit primaire est constitué d'un conducteur électrique formant un enroulement cylindrique 11 de section constante, disposé autour d'une des deux bobines 32, 33 du circuit secondaire et de façon symétrique par rapport au plan médian B-B. Le nombre Np de passages du conducteur primaire entre les bobines 32,33 est supérieur à 1, formant ainsi au moins une spire. Aux extrémités 11a et 11b de l'enroulement 11, le circuit primaire se prolonge respectivement par deux segments droits 12 et 13 du conducteur électrique, disposés de part et d'autre d'un plan vertical A-A, suivant l'axe vertical X, de telle manière que ces deux segments 12 et 13 puissent respectivement se raccorder par des moyens appropriés à des connecteurs 14 et 15 du circuit primaire. Ces connecteurs 14 et 15 sont symétriques par rapport au plan vertical A-A et sont dirigés suivant l'axe vertical X mais en sens opposé aux connecteurs 38, 39 du circuit secondaire. Le nombre Np de passages est variable de façon à pouvoir s'adapter à une large plage de réglage du courant primaire Ip.

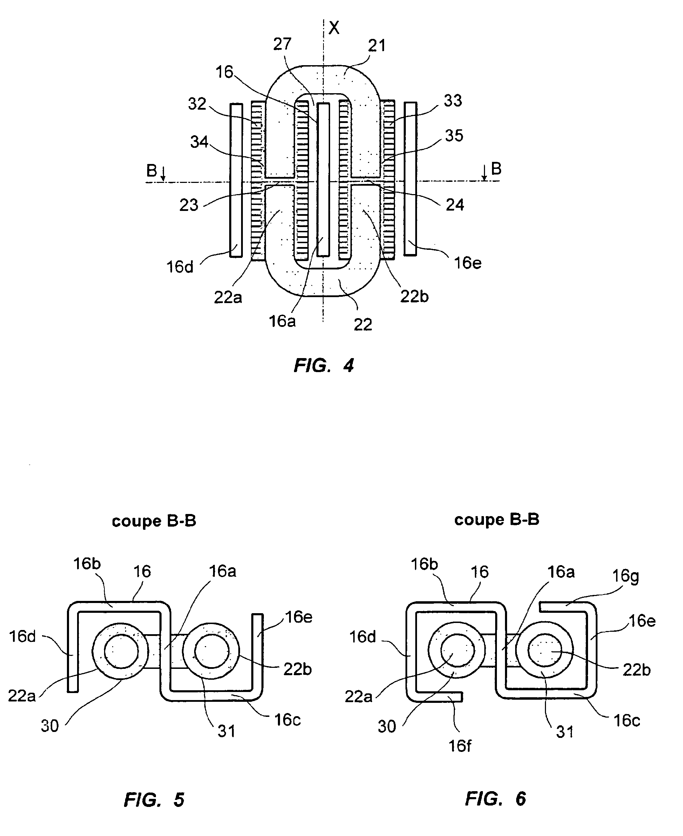

Dans un autre mode de réalisation schématisé en figure 4 et correspondant à une utilisation du capteur pour des valeurs importantes du courant primaire Ip, le nombre Np de passages du circuit primaire entre les bobines 32,33 est égal à 1, ce dernier ne faisant pas ainsi une spire complète. L'enroulement 11 du circuit primaire est remplacé par un conducteur plat 16 comportant une première plaque verticale 16a, parallèle à l'axe vertical X, orthogonale par rapport au plan vertical A-A et d'une hauteur sensiblement égale à la hauteur des bobines 32, 33 du circuit secondaire. Cette première plaque 16a traverse directement un espace 27 situé entre les deux bobines 32, 33, à égale distance des deux entrefers 23, 24 du circuit magnétique et de façon symétrique par rapport au plan médian B-B.

La disposition du conducteur plat 16 autour des bobines 32, 33 du circuit secondaire influence la linéarité du signal de sortie du capteur de courant. Les figures 5 et 6 montrent ainsi deux exemples possibles et non limitatifs de disposition dans lesquels le conducteur 16 entoure partiellement les bobines 32, 33 du circuit secondaire ce qui procure au capteur de courant une meilleure linéarité sur toute la plage de mesure. Dans la figure 5, la première plaque verticale 16a se prolonge par deux autres plaques verticales 16b, 16c orthogonales par rapport à la plaque 16a, puis, aux extrémités de ces plaques 16b, 16c par deux nouvelles plaques verticales 16d, 16e, orthogonales par rapport aux plaques 16b, 16c de façon à entourer partiellement chaque bobine 32, 33 du circuit secondaire, le conducteur 16 présentant ainsi la forme d'un S ou d'un Z suivant le plan de coupe B-B. Dans la figure 6, les plaques 16d, 16e sont elles-mêmes prolongées par deux nouvelles plaques verticales 16f, 16g, orthogonales par rapport aux plaques 16d, 16e et parallèles aux plaques 16b, 16c mais de largeur plus courte, de façon à entourer plus complètement les bobines 32, 33 du circuit secondaire. Les plaques 16a, 16b, 16c, 16d, 16e, 16f et 16g sont toutes symétriques par rapport au plan médian B-B et possèdent des hauteurs sensiblement égales.

Un des objectifs du capteur exposé dans la présente invention est de pouvoir être implanté sur plusieurs calibres d'appareils électriques de puissance permettant de couvrir la plus large plage de réglage du courant primaire Ip, tout en gardant un niveau de signal de sortie Vs sensiblement linéaire et identique pour tous les calibres envisagés, ceci de manière à rendre le traitement électronique situé en aval du capteur indépendant du calibre, de façon à simplifier la conception et la réalisation. Pour cela, le principe utilisé permet de moduler plusieurs paramètres notamment :
- le nombre Np de passages de l'enroulement 11 du circuit primaire autour des bobines 32,33,
- l'épaisseur E des pastilles 25, 26 des entrefers du circuit magnétique,
- le nombre Ns de spires des bobines 32, 33 du circuit secondaire.

Ces trois paramètres interviennent directement dans le coefficient de proportionnalité qui existe entre le signal de sortie Vs du capteur et la dérivée du courant primaire Ip. Ainsi quand le nombre Np augmente, le signal Vs augmente, de même quand le nombre Ns augmente, le signal Vs augmente, par contre quand l'épaisseur E augmente, le signal Vs diminue. En faisant judicieusement varier ces paramètres suivant les calibres, on peut ainsi obtenir un signal de sortie Vs sensiblement identique pour des plages de réglage du courant Ip différentes.

Dans un appareil électrique du type disjoncteur ou contacteur/disjoncteur, la plage de réglage du courant primaire correspond à la plage qu'un utilisateur peut régler pour son application entre la valeur efficace d'un courant minimum Imin et la valeur efficace d'un courant maximum Imax. En raison notamment du matériau utilisé dans le circuit magnétique, on est capable d'obtenir, dans la présente invention, un écart important entre Imin et Imax, tel que Imax = 4 * Imin, ce qui présente l'avantage de fournir une grande souplesse d'exploitation pour un calibre donné. Pour assurer une protection thermique, un capteur de courant doit être capable de faire une mesure du courant primaire Ip à partir de 0.5 * Imin. Pour assurer une protection magnétique et un déclenchement sur court-circuit, un capteur de courant doit être capable de faire une mesure jusqu'à 18 * Imax. Donc, pour un calibre donné et avec une plage de réglage du capteur égale à 4, la plage de mesure du capteur de courant est égale à 144.
Tout en conservant un même traitement électronique en aval du capteur, le tableau ci-après indique un exemple des différentes plages de réglage de la valeur efficace du courant primaire Ip, correspondant à différents calibres d'appareils électriques, qu'un capteur de courant suivant l'invention serait capable de couvrir en faisant varier le nombre Np de passages du circuit primaire entre les bobines 32,33, le nombre Ns de spires de l'enroulement secondaire et l'épaisseur E des pastilles 25,26 des entrefers.

| **Calibre** | **Np** | **Ns** | **E** |
|---|---|---|---|
| Imin - Imax (A) | | | (mm) |
| 0,1 - 0,4 | 8 | 2400 | 0,2 |
| 0,35 - 1,4 | 8 | 1400 | 0,65 |
| 1,25 - 5 | 3 | 1400 | 0,65 |
| 3 - 12 | 2 | 1400 | 0,65 |
| 4,5 - 18 | 1 | 1200 | 1 |
| 8 - 32 | 1 | 1400 | 3 |

Enfin, pour ce type de capteur, le signal de sortie délivré Vs doit notamment être intégré par un traitement électronique aval pour pouvoir travailler sur un signal proportionnel au courant primaire. Dans la présente invention, ce traitement électronique est réalisé uniquement par des composants passifs de type RC sans l'utilisation d'un composant intégrateur actif. Cette disposition donne des résultats suffisants et, de plus, permet de compenser naturellement les différentes fréquences usuelles des courants primaires (typiquement 50 Hz ou 60 Hz).

## Revendications

1. Capteur de courant implantable dans un appareil électrique pour assurer des fonctions de protection thermique, magnétique ou de court-circuit, lequel capteur de courant comporte :
- un circuit primaire dans lequel circule un courant électrique (Ip) à mesurer,
- un circuit secondaire faisant office de détecteur de champ magnétique,
- un circuit magnétique comprenant deux éléments identiques (21,22) en forme de U, composés d'un matériau ferromagnétique et possédant chacun une première et une seconde branches parallèles,
- ces deux éléments identiques (21, 22) étant disposés en vis-à-vis de telle manière qu'ils soient coplanaires,
- deux entrefers (23,24) ayant une épaisseur (E) sensiblement égale, situés respectivement entre chaque première branche et chaque seconde branche des éléments,
le circuit secondaire comportant deux bobines similaires (32,33) de plusieurs spires, de forme cylindrique, montées en série, chaque bobine du circuit secondaire étant disposée de façon symétrique par rapport à un plan médian (B-B) passant par les entrefers (23,24) du circuit magnétique,
**caractérisé par le fait que** les deux bobines (32,33) sont réalisées en continu par une seule opération de bobinage sans soudure entre les deux bobines, et **par le fait que** le circuit primaire est constitué d'un conducteur électrique formant un enroulement de forme cylindrique (11) de section constante, entourant une des deux bobines (32,33) du circuit secondaire et disposé de façon symétrique par rapport au plan médian (B-B), ledit conducteur faisant un nombre (Np) de passages entre les bobines (32,33) supérieur à 1.

2. Capteur de courant selon la revendication 1, **caractérisé par le fait qu'**en faisant varier le nombre (Np) de passages du circuit primaire autour des bobines (32,33) du circuit secondaire, le nombre (Ns) de spires du circuit secondaire et l'épaisseur (E) des entrefers, le capteur de courant est conçu pour délivrer un signal de sortie (Vs) sensiblement linéaire et identique pour différentes plages de réglage du courant primaire (Ip) permettant d'implanter le capteur dans plusieurs calibres d'appareils électriques.

3. Capteur de courant selon la revendication 1, **caractérisé par le fait que** les deux éléments (21,22) du circuit magnétique sont réalisés à partir d'un profilé étiré de section circulaire composé d'un alliage Fer-Nickel comportant au minimum 36% de Nickel et sur lequel est opérée une opération de recuit magnétique.

4. Appareil électrique **caractérisé par le fait qu'**il comporte au moins un capteur de courant selon l'une des revendications précédentes.

## Claims

1. Current sensor implantable in an electric device for providing thermal, magnetic or short-circuit protection functions, which current sensor comprises:
- a primary circuit in which an electric current (Ip) to be measured flows,
- a secondary circuit acting as magnetic field detector,
- a magnetic circuit comprising two identical U-shaped elements (21, 22), composed of a ferromagnetic material and each possessing a first and a second parallel branch,
- these two identical elements (21, 22) being disposed opposite one another in such a way that they are coplanar,
- two air gaps (23, 24) having a substantially equal thickness (E), situated respectively between each first branch and each second branch of the elements,
- the secondary circuit comprising two similar coils (32, 33) of several turns, of cylindrical shape, arranged in series, each coil of the secondary circuit being positioned symmetrically with respect to a median plane (B-B) passing through the air gaps (23, 24) of the magnetic circuit,
**characterized in that** the two coils (32, 33) are produced continuously by a single operation of coiling without welding between the two coils, and **in that** the primary circuit consists of an electrical conductor forming a winding of cylindrical shape (11) of constant cross section, surrounding one of the two coils (32, 33) of the secondary circuit and positioned symmetrically with respect to the median plane (B-B), the said conductor making a number (Np) of passes between the coils (32, 33) which is greater than 1.

2. Current sensor according to Claim 1, **characterized in that** by varying the number (Np) of passes of the primary circuit around the coils (32, 33) of the secondary circuit, the number (Ns) of turns of the secondary circuit and the thickness (E) of the air gaps, the current sensor is designed to deliver an output signal (Vs) which is substantially linear and identical for various ranges of adjustment of the primary current (Ip) making it possible to implant the sensor in several gauges of electrical devices.

3. Current sensor according to Claim 1, **characterized in that** the two elements (21, 22) of the magnetic circuit are produced from a stretched profile of circular cross section composed of an iron-nickel alloy comprising a minimum of 36% nickel and on which a magnetic annealing operation is performed.

4. Electrical device **characterized in that** it comprises at least one current sensor according to one of the preceding claims.

## Patentansprüche

1. Stromsensor, der in ein elektrisches Gerät eingesetzt werden kann, um Funktionen des Wärmeschutzes, des magnetischen Schutzes oder des Kurzschlussschutzes zu gewährleisten, wobei der Stromsensor aufweist:
- einen Primärkreis, in dem ein zu messender elektrischer Strom (Ip) fließt,
- einen Sekundärkreis, der als Magnetfelddetektor dient,
- einen Magnetkreis, der zwei gleiche Elemente (21, 22) in Form eines U aufweist, die aus einem ferromagnetischen Material bestehen und je einen ersten und einen zweiten parallelen Zweig besitzen,
- wobei diese beiden gleichen Elemente (21, 22) so einander gegenüber angeordnet sind, dass sie koplanar sind,
- zwei Luftspalte (23, 24) mit im Wesentlichen gleicher Dicke (E), die sich je zwischen jedem ersten Zweig und jedem zweiten Zweig der Elemente befinden,
wobei der Sekundärkreis zwei gleiche Spulen (32, 33) mit mehreren Windungen von zylindrischer Form aufweist, die in Reihe geschaltet sind, wobei jede Spule des Sekundärkreises bezüglich einer Mittelebene (B-B) symmetrisch angeordnet ist, die durch die Luftspalte (23, 24) des Magnetkreises verläuft,
**dadurch gekennzeichnet, dass** die zwei Spulen (32, 33) kontinuierlich durch einen einzigen Wickelvorgang ohne Lötstelle zwischen den beiden Spulen hergestellt werden, und dadurch, dass der Primärkreis aus einem elektrischen Leiter besteht, der eine Wicklung zylindrischer Form (11) mit konstantem Querschnitt bildet, die eine der beiden Spulen (32, 33) des Sekundärkreises umgibt und symmetrisch bezüglich der Mittelebene (B-B) angeordnet ist, wobei der Leiter eine Anzahl (Np) von Durchgängen zwischen den Spulen (32, 33) größer als 1 durchführt.

2. Stromsensor nach Anspruch 1, **dadurch gekennzeichnet, dass** durch Variieren der Anzahl (Np) von Durchgängen des Primärkreises um die Spulen (32, 33) des Sekundärkreises, der Anzahl (Ns) von Windungen des Sekundärkreises und der Dicke (E) des Luftspalts der Stromsensor konzipiert wird, um ein im Wesentlichen lineares und gleiches Ausgangssignal (Vs) für verschiedene Regelbereiche des Primärstroms (Ip) zu liefern, das es ermöglicht, den Sensor in mehreren Nennbereichen von elektrischen Geräten einzusetzen.

3. Stromsensor nach Anspruch 1, **dadurch gekennzeichnet, dass** die zwei Elemente (21, 22) des Magnetkreises ausgehend von einem gestreckten Profilteil mit kreisförmigem Querschnitt hergestellt werden, das aus einer Eisen-NickelLegierung besteht, die mindestens 36% Nickel enthält und an der eine Magnetfeldglühung durchgeführt wird.

4. Elektrisches Gerät, **dadurch gekennzeichnet, dass** es mindestens einen Stromsensor nach einem der vorhergehenden Ansprüche aufweist.
